# EUROPEAN PATENT APPLICATION

(11) **EP 4 787 438 A1**
(43) Date of publication of application: **05.08.2026**
(21) Application number: 23866746.3
(22) Date of filing: 25.09.2023
(51) Int. Cl.: H01L 31/0216, H01L 31/0224

(54) **PHOTOVOLTAIC CELL, USE OF NIOBIUM NANOPARTICLES, METHOD OF PRODUCING ENERGY AND METHOD FOR INCREASING THE QUANTUM EFFICIENCY OF PHOTOLUMINESCENCE IN A SOLAR CELL**

(71) Applicant: Instituto Hercílio Randon, 95181899 Farroupilha (BR)
(72) Inventor: BOARETTO, Joel, 95032-180 Caxias do Sul (BR); CRUZ, Robinson Carlos Dudley, 95020-472 Caxias do Sul (BR); CID, Cristiani Campos Plá, 88025-000 Florianópolis (BR)
(74) Representative: WSL Patentanwälte Partnerschaft mbB
(86) International application number: PCT/BR2023/050319
(87) International publication number: WO 2024/059924

(57) **Abstract**

The present invention relates to a photovoltaic cell, particularly for use in solar panel. The invention solves several problems of the prior art and provides a photovoltaic cell that exhibits higher photon conversion efficiency (PCE). The invention also provides a significantly longer lifespan compared to photovoltaic cells of the prior art. The invention provides a photovoltaic cell comprising a mass quantity of niobium nanoparticles in at least one of its layers, wherein in one embodiment, said mass quantity of niobium nanoparticles is comprised within a protective layer against radiation in the ultraviolet (UV) range. The present invention pertains to the technical fields of materials science, electrochemistry, and nanotechnology.

## Description

### Field of the Invention

The present invention relates to a photovoltaic cell, particularly for use in solar panel. Additionally, it relates to the use of niobium nanoparticles as a component of at least one layer of the photovoltaic cell. The present invention pertains to the technical fields of materials science, electrochemistry, and nanotechnology.

### Background of the Invention

Currently, sustainable development is a socio-economic-environmental model that is directly related to economic growth in a way so as to ensure social inclusion and environmental protection. In this context, clean technologies emerge, which are new industrial processes or changes made to existing processes intended to reduce the consumption of raw materials, energy consumption, environmental impacts and waste. This need creates opportunities for the development of new clean energy generation technologies.

While searching for cleaner technologies, alternative energy sources such as solar panels have emerged as an attractive alternative since they are not polluting compared to, for example, burning fossil fuels, and they use renewable sources (e.g., sunlight) to generate energy.

The main component of a solar cell is the semiconductor, which is responsible for converting the energy absorbed from photons of light into electrical current. Generally, a semiconductor is a material that comprises a relatively small energy difference between the valence band and the conduction band of the material, such that the energy absorbed from the photon of light is able to excite an electron that is promoted from the valence band to the conduction band, leaving an unoccupied state in the valence band called a 'hole' which has a positive charge (opposite to the electrons charge). Electrons are collected by the cathode while holes are collected by the anode, and thus an electric current is generated.

The first generation of solar panels comprises silicon as the active layer. The second generation of solar panels includes materials such as gallium arsenide, cadmium telluride, and indium gallium copper selenide in the active layer. The third generation of solar panels includes dye-sensitized, organic, and perovskite solar cells as the active material.

Perovskite solar cells (PSCs) exhibit excellent optoelectronic properties, and their manufacture is simpler and more economical compared to silicon solar cells. Despite exhibiting efficiencies similar to silicon devices (around 25%), PSCs present stability problems when exposed to high-energy radiation (wavelengths shorter than 450 nm). To protect devices from this radiation without compromising cell performance, LDS (Luminescent Down-Shifting) luminescent coatings are used. The LDS layer is deposited on top of the device, on the transparent conductive substrate (ITO, FTO), thus preventing the active layer from receiving higher energy photons (ultraviolet radiation range), while simultaneously converting their energy to values corresponding to the visible range of the electromagnetic spectrum, thus contributing to an increase in the number of photogenerated charges in the active layer.

When absorbing light in regions near the blue and UV, LDS layers protect devices from damaging radiation; when re-emitting this radiation at longer (less energetic) wavelengths, it is also possible to increase the efficiency of the devices, since this re-emitted radiation can be shifted to wavelengths where photoconversion in the active layer is more likely.

The article by Anizelli et al. (titled "*Application of luminescence downshifting materials for enhanced stability of CH₃NH₃PbI₃₍₁₋ₓ₎Cl₃ₓ perovskite photovoltaic devices*") published in 2017 discusses the results of applying LDS layers to a CH₃NH₃PbI₃ photovoltaic device. In the results presented by Anizelli et al. (2017) we can see the example of the LDS layer compound Kremer blue:PMMA (Kb), which absorbs at wavelengths between 320 and 420 nm and re-emits between 400 and 550 nm. In the range where Kremer blue re-emits, the external quantum efficiency (EQE) of the CH₃NH₃PbI₃ device is higher.

As a result of applying this Kb LDS film in article Anizelli et al. (2017), a 7-fold increase in the average lifespan of the photovoltaic device was observed. However, with the use of this LDS film, the photon conversion efficiency (PCE) decreased by approximately 18%. This decrease in photoconversion is due, among other things, to a low photoluminescence quantum yield (PLQY) and to the overlap between the absorption and emission peaks of the material, which leads to reabsorption losses.

In view of the above, it is clear that the search for renewable, accessible and clean technologies is a constant need, since the generation of energy through conventional means, such as the combustion of diesel, natural gas and liquefied petroleum gas, entails several harmful environmental and socioeconomic effects. Nevertheless, the development of solar cells with longer lifespans combined with high photon conversion efficiency (PCE) is a constant pursuit in this technical field.

Based on the literature reviewed, no documents were found that anticipated or suggested the teachings of the present invention, so the solution proposed herein, in the inventors' point of view, has novelty and inventive activity compared to the prior art.

### Summary of the Invention

The present invention solves several problems of the prior art and provides a photovoltaic cell that exhibits higher photon conversion efficiency (PCE). The invention also provides a significantly longer lifespan compared to photovoltaic cells of the prior art. The invention provides a photovoltaic cell comprising a mass quantity of niobium nanoparticles in at least one of its layers, wherein, in one embodiment, said mass quantity of niobium nanoparticles is comprised within a protective layer against radiation in the ultraviolet (UV) range.

In the context of the present invention, the expression "niobium nanoparticle" encompasses various chemical entities containing niobium, including metallic niobium, niobium oxides, hydrates, hydrides, carbides, or nitrides, niobium iron or niobium alloyed with other metals or transition metals, or combinations thereof. It also includes niobium pentoxide (Nb₂O₅), NbO₂, and NbO.

Brazil has significant niobium reserves. One advantage of the present invention is that it allows the use of this element for the production of more efficient battery cells.

In a first object, the present invention discloses the use of niobium nanoparticles as a dopant for at least one layer of a photovoltaic cell, wherein said nanoparticles comprise a degree of amorphization of at least 19%.

In a second object, the present invention provides a photovoltaic cell comprising:
- an active layer;
- an electron transport layer in contact with one face of the active layer;
- a hole transport layer in contact with one face of the active layer;
- a transparent conductive substrate in contact with the electron transport layer or the hole transport layer;
- a counter electrode in contact with the electron transport layer or the hole transport layer; additionally comprising:
- a protective layer in contact with the transparent conductive substrate;
wherein at least one of said layers comprises a mass quantity of niobium nanoparticles, wherein said mass quantity of nanoparticles comprises a degree of amorphization of at least 19%.

In one embodiment, the mass quantity of niobium nanoparticles is comprised within said protective layer.

In a third object, the present invention defines a method of producing energy comprising a step of incidence of electromagnetic radiation on the photovoltaic cell as defined above.

In a fourth object, the present invention defines a method for increasing the photoluminescence quantum yield in a solar cell comprising at least one step of incorporating niobium nanoparticles into at least one protective layer of said solar cell, wherein said protective layer is in contact with the transparent conductive substrate of said solar cell.

These and other objects of the invention will be readily appreciated by those skilled in the art and will be described in detail below.

### Brief Description of the Figures

The following figures are presented:
Fig. 1 illustrates an EQE curve of a reference PSC device (black curve) and an EQE curve of a device with a LDS layer of Alq3:PMMA (red curve).
Fig. 2 illustrates an EQE curve of a reference PSC device (black curve) and an EQE curve of the device with a LDS layer of Alq3:PMMA:Nb₂O₅ (red curve). The effect of Nb₂O₅ nanoparticles is to increase the EQE of the device in the UV region (300-400 nm).
Fig. 3 illustrates, on the left (A), an emission spectrum (PL - photoluminescence ) of Nb₂O₅ nanoparticles excited with a source of 305 nm. It also illustrated, on the right (B), an absorption spectrum of the luminescent compound Alq3:PMMA.
Fig. 4 shows an emission spectrum (PL - photoluminescence ) of Alq3:PMMA:Nb₂O₅ blend excited with a source of 305 nm.
Fig. 5 shows the UV-visible absorption profile of Alq3 solutions at concentrations of 4 mg/mL, 2 mg/mL, and 1 mg/mL heated at 80°C for 15 min.
Fig. 6 shows an emission spectrum (PL - photoluminescence ) of Alq3 solutions at concentrations of 4 mg/mL, 2 mg/mL, and 1 mg/mL heated at 80°C for 15 min.
Fig. 7 shows the UV-visible absorption profile of Alq3 solutions at concentrations of 4 mg/mL, 2 mg/mL, and 1 mg/mL heated at 80°C for 30 min.
Fig. 8 shows an emission spectrum (PL - photoluminescence ) of Alq3 solutions at concentrations of 4 mg/mL, 2 mg/mL, and 1 mg/mL heated at 80°C for 30 min.
Fig. 9 shows an emission spectrum (PL - photoluminescence) of polymer solutions prepared as described in Example 1 for Alq3:PMMA composites heated at 120°C for 15 min, 120°C for 45 min, 120°C for 1 h, 100°C for 15 min, 100°C for 45 min, 100°C for 1 h.
Fig. 10 shows the UV-visible absorption profile of Alq3 solutions at a concentration of 0.4 mg/mL compared with mixtures of Nb and Alq3 nanoparticles at different ratios (3:4; 1:2, and 3:8).
Fig. 11 shows the UV-visible absorption profile of Alq3:PMMA polymer solutions at concentrations of 0.4 mg/mL and 0.6 mg/mL compared to an Alq3:PMMA polymer solution at a concentration of 0.6 mg/mL containing Nb nanoparticles (1 mg/mL).
Fig. 12 shows an emission spectrum (PL - photoluminescence) of the polymer solutions shown in Fig. 11.
Fig. 13 shows an emission spectrum (PL - photoluminescence) of niobium nanoparticle solutions at different concentrations in deionized water.
Fig. 14 shows an emission spectrum (PL - photoluminescence) of niobium nanoparticle solutions at different concentrations in acetone.
Fig. 15 shows an emission spectrum (PL - photoluminescence) of polymer solutions deposited on a transparent ITO (indium tin oxide) substrate: ITO with niobium nanoparticles, ITO with PMMA (1%), and ITO with niobium nanoparticles in PMMA (1%) heated to 60°C for 15 min, except for the ITO sample.
Fig. 16 shows an emission spectrum (PL - photoluminescence) of polymer solutions deposited on PET (polyethylene terephthalate) substrate with niobium nanoparticles, PET (polyethylene terephthalate) with niobium nanoparticles in PMMA (1%) heated to 60°C for 15 min.
Fig. 17 shows an emission spectrum (PL - photoluminescence) of niobium nanoparticle solutions at a concentration of 2.5 mg/mL in acetone, heated to 60°C for 10 min or 20 min (in triplicate).
Fig. 18 shows a graph of current (A) versus voltage (V) for measuring the resistance (Ω) of a PMMA/ITO sample.
Fig. 19 shows a graph of current (A) versus voltage (V) for measuring the resistance (Ω) of an ITO/PET/PMMA sample.
Fig. 20 shows a graph of current (A) versus voltage (V) for measuring the resistance (Ω) of an ITO sample.
Fig. 21 shows a graph of current (A) versus voltage (V) for measuring the resistance (Ω) of an ITO sample with niobium nanoparticles treated at 60°C for 15 min.
Fig. 22 shows a graph of current (A) versus voltage (V) for measuring the resistance (Ω) of an ITO/PET sample.
Fig. 23 shows a graph of current (A) versus voltage (V) for measuring the resistance (Ω) of a PET sample with niobium nanoparticles treated at 60°C for 15 min.
Fig. 24 shows a graph of current (A) versus voltage (V) for measuring the resistance (Ω) of an ITO sample with niobium nanoparticles in PMMA.

### Detailed Description of the Invention

The present invention discloses an improved photovoltaic cell. The photovoltaic cell of the invention exhibits higher photon conversion efficiency (PCE). It also shows a significantly longer lifespan compared to photovoltaic cells of the prior art. The photovoltaic cell of the invention comprises a mass quantity of niobium nanoparticles in at least one of its layers, wherein, in one embodiment, said mass quantity of niobium nanoparticles is comprised within a protective layer against radiation in the ultraviolet (UV) range.

In the context of the present invention, the expression "niobium nanoparticle" encompasses various chemical entities containing niobium, including metallic niobium, niobium oxides, hydrates, hydrides, carbides, or nitrides, niobium iron or niobium alloyed with other metals or transition metals, or combinations thereof. It also includes niobium pentoxide (Nb₂O₅), NbO₂, and NbO.

One object of the present invention is to provide for the production and to obtain more efficient photovoltaic cells.

In one object, the present invention provides a photovoltaic cell comprising:
- an active layer;
- an electron transport layer in contact with one face of the active layer;
- a hole transport layer in contact with one face of the active layer;
- a transparent conductive substrate in contact with the electron transport layer or the hole transport layer;
- a counter electrode in contact with the electron transport layer or the hole transport layer; additionally comprising:
- a protective layer in contact with the transparent conductive substrate;
wherein at least one of said layers comprises a mass quantity of niobium nanoparticles, wherein said mass quantity of nanoparticles comprises a degree of amorphization of at least 19%.

In one embodiment, the mass quantity of niobium nanoparticles is comprised within said protective layer.

In one embodiment, said mass quantity of nanoparticles preferably comprises a degree of amorphization of at least 20%, more preferably at least 25%, more preferably at least 30%, more preferably at least 35%, more preferably at least 39%, more preferably at least 40%, more preferably at least 45%, more preferably at least 50%, more preferably a degree of amorphization of at least 55%, more preferably at least 60%, more preferably at least 65% and even more preferably a degree of amorphization of at least 70%. In one embodiment, the degree of amorphization is at least 71%, more preferably at least 72%, more preferably at least 73%. In a non-limiting embodiment, the degree of amorphization is 74%.

In one embodiment, said mass quantity of nanoparticles preferably comprises a degree of amorphization of at least 39%, preferably a degree of amorphization of at least 55% and even more preferably a degree of amorphization of at least 70%.

In the context of the present invention, the term "protective layer" should be understood as a layer that is capable of protecting the photovoltaic cell against damaging electromagnetic radiation, such as, but not limited to, an LDS-type layer. Said protective layer can be made of a wide variety of materials, including, but not limited to, synthetic or natural polymers that are transparent to visible radiation and, at the same time, exhibit significant absorption of UV radiation. Non-limiting examples of said polymer may include PMMA (polymethyl methacrylate).

Thus, in one embodiment, said protective layer is composed of synthetic or natural polymers that are transparent to visible radiation.

In one embodiment, said protective layer is composed of synthetic or natural polymers that are transparent to visible radiation and exhibit significant absorption of UV radiation.

In one particular, non-limiting embodiment, said polymer is composed of PMMA. In one particular, non-limiting embodiment, said protective layer is composed of PMMA and Alq3 dye.

In an alternative embodiment, said protective layer could be composed of a paste of nanoparticles (without the use of polymer).

The LDS layer is deposited on top of the device, on the transparent conductive substrate, thus preventing the active layer from receiving higher energy photons (ultraviolet radiation range), while simultaneously converting their energy to values corresponding to the visible range of the electromagnetic spectrum, thus contributing to an increase in the number of photogenerated charges in the active layer.

When absorbing light in regions near the blue and UV, LDS layers protect devices from damaging radiation; when re-emitting this radiation at longer (less energetic) wavelengths, it is also possible to increase the efficiency of the devices, since this re-emitted radiation can be shifted to wavelengths where photoconversion in the active layer is more likely.

In the context of the present invention, the expression "degree of amorphization" should be understood as the extent to which a material exhibits a predominantly disordered structure arrangement, as opposed to crystalline, predominantly monocrystalline and/or polycrystalline phases. "Amorphization" can be understood as a process of loss of long-range ordered array of atoms, molecules, or ions in the crystalline structure of a given material, although it may also exhibit a short-range ordered array.

In one embodiment of said photovoltaic cell, the active layer is composed of perovskite. In one embodiment, said perovskite is a material with a crystal structure of the type ABX₃. Non-limiting examples of said perovskite may be CsFAMAPb(IₓBr₁₋ₓ)₃, MAPbI₃, CsFAPbI₃, CH₃NH₃PbI₃ or combinations thereof.

In one embodiment of said photovoltaic cell, the niobium nanoparticle is a niobium pentoxide nanoparticle.

In one embodiment of said photovoltaic cell, the electron transport layer is composed of TiO₂, SnO₂, Zn_{O}, PCBM, C₆₀, or combinations thereof.

In one embodiment of said photovoltaic cell, the hole transport layer is composed of Spiro-OMeTAD, PTAA, P3HT, PEDOT:PSS, or combinations thereof.

In one embodiment of said photovoltaic cell, the transparent conductive substrate is composed of ITO, FTO, and PET (polyethylene terephthalate), or combinations thereof.

In one embodiment of said photovoltaic cell, the counter electrode is composed of Au, Al, Ag, or combinations thereof.

In a second object, the present invention discloses the use of niobium nanoparticles as a dopant for at least one layer of a photovoltaic cell, wherein said nanoparticles comprise a degree of amorphization of at least 19%.

In one embodiment of use of niobium nanoparticles, the niobium nanoparticle is a niobium pentoxide nanoparticle (Nb₂O₅), NbO₂, NbO ,or combinations thereof. In one embodiment of use of niobium nanoparticles, the niobium nanoparticle is a niobium pentoxide nanoparticle.

In a third object, the present invention defines a method of producing energy comprising a step of incidence of electromagnetic radiation on the photovoltaic cell as defined above.

In one embodiment of the method of producing energy, the energy is solar energy, and the so-called electromagnetic radiation comes from the sun.

In a fourth object, the present invention defines a method for increasing the photoluminescence quantum yield in a solar cell comprising at least one step of incorporating niobium nanoparticles into at least one protective layer of said solar cell, wherein said protective layer is in contact with the transparent conductive substrate of said solar cell.

In one embodiment of the method for increasing the photoluminescence quantum yield in a solar cell, the protective layer is composed of PMMA and Alq3 dye.

### Examples

The examples shown here are intended only to exemplify one of the several ways of carrying out the invention, however without limiting the scope thereof.

### Example 1 - Substrate preparation

The polymer solutions were prepared using PMMA powder (supplied by Sigma Aldrich) dissolved in acetone (preliminary tests with a final concentration of 3 wt%). The solution was stirred for 24 hours at room temperature.

The luminescent material solutions were prepared by adding aluminum hydroxyquinoline powder (Alq3, supplied by Sigma Aldrich) to the polymer solution (preliminary tests with a concentration of 0.08 mg of Alq3 per ml of PMMA solution). Similarly, the solution containing the luminescent material was stirred for 24 hours at room temperature to ensure solution homogeneity.

In order to prepare niobium pentoxide nanoparticles, a Labstar LS01 ball mill equipment (Netzsch) was fed with micrometric particles of niobium pentoxide. Said process involves high-energy wet milling. The particle suspension was 17.7% by mass, consisting of approximately 3500 g of milli-Q water + 10 M NaOH and 750 g of the solid sample, which was prepared and stabilized in the mill mixing tank at pH 9 and titrated with 10 M NaOH. The milling spheres used were yttria-stabilized zirconia, 400 µm in diameter. The milling chamber was filled to 80% by volume and the suspension temperature was below 40°C. The mill rotation speed was set to 3000 rpm and milling was conducted for 8 hours. To stabilize the suspension at pH 9, 10 M NaOH was added during milling, and samples were taken from time to time in order to measure particle sizes.

In the present example, several embodiments of nanoparticle preparations of Niobium pentoxide were obtained, with purity greater than 99%. Commercial Niobium pentoxide, with the particle size distribution described in Table 1, was pre-comminuted in a high-energy mill containing Yttria-stabilized zirconia spheres with a diameter of 400 µm, in a liquid medium and the pH adjusted to 6.6. The mill rotation speed was 3500 rpm, and the particle milling was carried out at a temperature below 40°C. Table 4 shows the particle size distribution (PSD) of incoming (commercial product) and outgoing niobium pentoxide from a pre-comminution step.

**Table 1 - Input PSD (commercial product) and output after pre-comminution.**

| **PSD for niobium pentoxide** | | |
|---|---|---|
| **cumulative %** | **diameter [µm]** | |
| | **Input** | **Output** |
| 1.13 | 2.130 | 0.991 |
| 2.97 | 4.030 | 1.450 |
| 4.87 | 6.720 | 1.880 |
| 6.22 | 8.680 | 2.130 |
| 10.00 | 13.400 | 2.770 |
| 12.72 | 16.400 | 3.120 |
| 15.03 | 18.700 | 3.550 |
| 17.96 | 21.200 | 4.030 |
| 21.73 | 24.100 | 4.580 |
| 26.56 | 27.400 | 5.210 |
| 32.68 | 31.100 | 6.120 |
| 40.22 | 35.300 | 7.440 |
| 50.00 | 40.600 | 8.880 |
| 59.08 | 45.600 | 10.160 |
| 69.48 | 51.800 | 12.700 |
| 79.47 | 58.900 | 16.500 |
| 88.11 | 66.900 | 21.200 |
| 94.59 | 76.000 | 27.400 |
| 98.55 | 86.400 | 35.300 |
| 99.99 | 98.100 | 40.100 |

The mean specific surface area S (m²/g) of the particles after the pre-comminution step was 0.32 m²/g.

In one embodiment, the pre-comminuted particles were then fed to a high-energy mill, applying conditions like those described above, but with Zr spheres of 200 µm and milling for different times, until each nanoparticle preparation was obtained. Three different nanoparticle preparations were obtained, each with a defined particle size distribution as described in Table 2.

**Table 2 - Particle size distribution of three different preparations (C, D and E) of Niobium pentoxide nanoparticles.**

| **PSD for niobium pentoxide** | | | |
|---|---|---|---|
| **cumulative %** | **diameter [µm]** | | |
| | **C** | **D** | **E** |
| 1.13 | 0.074 | 0.021 | 0.009 |
| 2.97 | 0.082 | 0.024 | 0.010 |
| 4.87 | 0.098 | 0.027 | 0.012 |
| 6.22 | 0.104 | 0.029 | 0.012 |
| 10.00 | 0.119 | 0.033 | 0.014 |
| 12.72 | 0.131 | 0.036 | 0.016 |
| 15.03 | 0.138 | 0.038 | 0.017 |
| 17.96 | 0.145 | 0.040 | 0.017 |
| 21.73 | 0.159 | 0.044 | 0.019 |
| 26.56 | 0.175 | 0.048 | 0.021 |
| 32.68 | 0.192 | 0.053 | 0.023 |
| 40.22 | 0.212 | 0.058 | 0.025 |
| 50.00 | 0.243 | 0.067 | 0.029 |
| 59.08 | 0.282 | 0.078 | 0.034 |
| 69.48 | 0.322 | 0.089 | 0.038 |
| 79.47 | 0.376 | 0.104 | 0.045 |
| 88.11 | 0.413 | 0.114 | 0.049 |
| 94.59 | 0.455 | 0.125 | 0.054 |
| 98.55 | 0.550 | 0.152 | 0.066 |
| 99.99 | 0.747 | 0.206 | 0.089 |

In the examples of this application, even more surprising results were found for the samples that were subjected to 12 hours of milling.

Without wishing to be bound by theory, it is understood that the samples subjected to 12 hours of milling, which exhibit a higher degree of amorphization (74%), contribute to the surprising effects presented.

Nb₂O₅ nanoparticles (produced as described in WO2022036427) were added to the polymer solution simultaneously with the luminescent compound. The weight ratio of nanoparticles and Alq3 in preliminary tests was 1:1. The amount of Nb₂O₅ nanoparticles tested was 0.08 ± 0.02 mg per mL of solution. Nanoparticles with average size distributions of 500 nm (IHR01) and 100 nm (IHR12) were tested.

Glass substrates measuring 1 cm x 1 cm were washed with neutral soap, acetone, isopropyl alcohol, and deionized water. The substrates were stirred under ultrasound for 10 minutes in each of the solvents mentioned. LDS films were deposited by drop casting using 0.1 ml of luminescent solution onto a glass substrate, and subsequently the substrate was heated to different temperatures (60, 80, 100, and 120°C) for different time intervals (15, 30, and 45 min). Preliminary tests were performed by drying the samples at 80°C for 30 min.

### Example 2 - Incorporation of Alq3 (aluminum tris(8-hydroxyquinolinate) - C₂₇H₁₈AlN₃O₃)

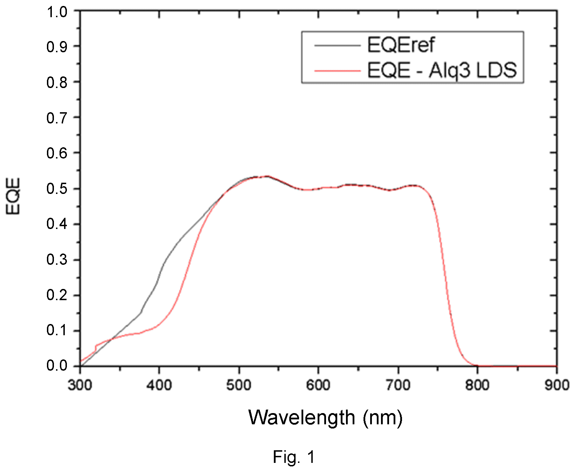

Alq3 (aluminum tris(8-hydroxyquinolinate) - C₂₇H₁₈AlN₃O₃) is an easily synthesizable and inexpensive luminescent dye with desirable optical properties for use in LDS layers applied to photovoltaic devices. Despite these good optical properties, low PLQY values (12.5%) induce significant losses in the device EQE (as can be seen in Fig. 1), with decreases of -6.86% in the short-circuit current density (J_{sc}).

Fig. 1 illustrates an EQE curve of a reference PSC device (black curve) and an EQE curve of a device with a LDS layer of Alq3:PMMA (red curve).

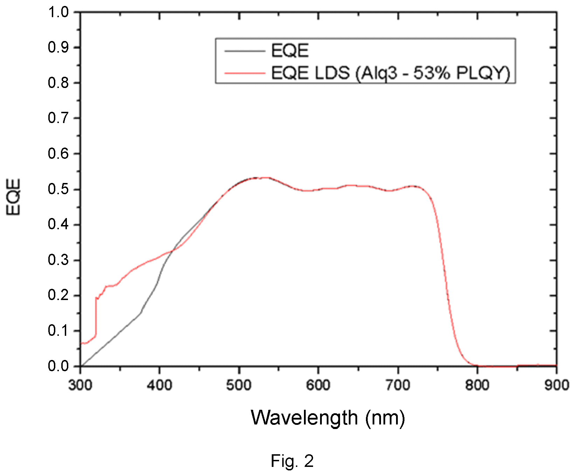

By changing the concentrations of PMMA and dye, it is possible to increase the PLQY values in Alq3 LDS films. The highest value obtained so far was 32%. Using the Rothemund model, we notice that the use of these films would still lead to a decrease in the device EQE, with a loss of -1.5% in J_{sc}. By adding niobium pentoxide nanoparticles (Nb₂O₅), PLQY values of 53% were obtained. Based on calculations using the model from Rothemund article (titled "*Optical modelling of the external quantum efficiency of solar cells with luminescent down-shifting layers*") published in 2014, the use of these films would lead to an increase in the EQE of the device (as can be seen in Fig. 2), with an increase of 2.29% in J_{sc}.

Fig. 2 illustrates an EQE curve of a reference PSC device (black curve) and an EQE curve of the device with a LDS layer of Alq3:PMMA:Nb₂O₅ (red curve). The effect of Nb₂O₅ nanoparticles is to increase the EQE of the device in the UV region (300-400 nm).

By mixing Nb₂O₅ in appropriate ratios, it is possible to induce greater gains in the final EQE of the device through an optimization process. The observed increase in PLQY of Alq3 LDS films with the addition of Nb₂O₅ nanoparticles may be related to a Föster energy transfer.

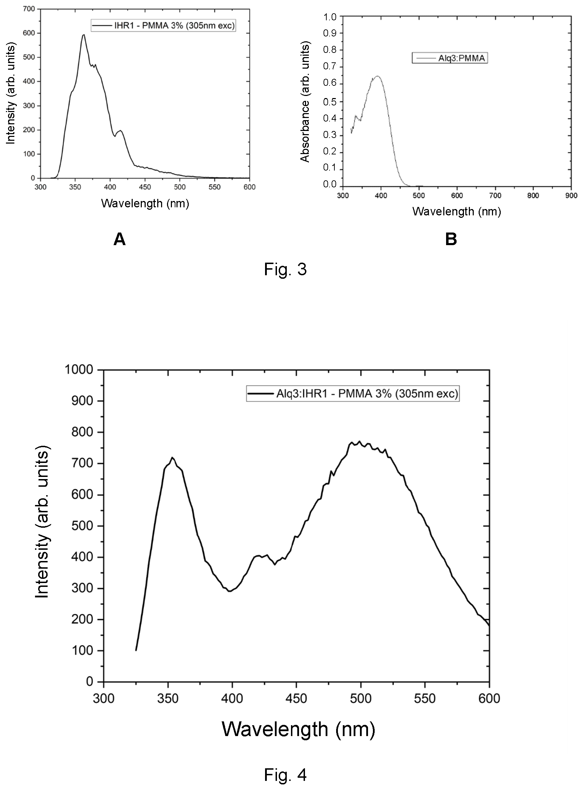

Fig. 3 illustrates, on the left (A), an emission spectrum (PL - photoluminescence ) of Nb₂O₅ nanoparticles excited with a source of 305 nm. It also illustrated, on the right (B), an absorption spectrum of the luminescent compound Alq3:PMMA.

As can be seen in Fig. 3, when exciting Nb₂O₅ at shorter wavelengths (305 nm), this compound emits at wavelengths between 330 and 430 nm, which overlaps with the absorption of Alq3:PMMA. This overlap in the emission-absorption spectra may be a sign of a Föster energy transfer. An efficient transfer would lead to an increase in PLQY of the final blend, since the final blend would emit in the Alq3 emission band at excitation wavelengths relative to the Nb₂O₅ nanoparticles (< 330 nm). This was confirmed with steady-state fluorescence measurements, as can be seen in Fig. 4. Steady-state photoluminescence measurements of the Alq3:PMMA:Nb₂O₅ blend show the characteristic simultaneous emission of each material.

Fig. 4 shows an emission spectrum (PL - photoluminescence ) of Alq3:PMMA:Nb₂O₅ blend excited with a source of 305 nm.

### Example 3 - Measurements and comparison of PLQY (Photoluminescence Quantum Yield)

Samples produced as described in Example 1 were prepared to demonstrate the increase in PLQY when using a protective layer as described in the present invention.

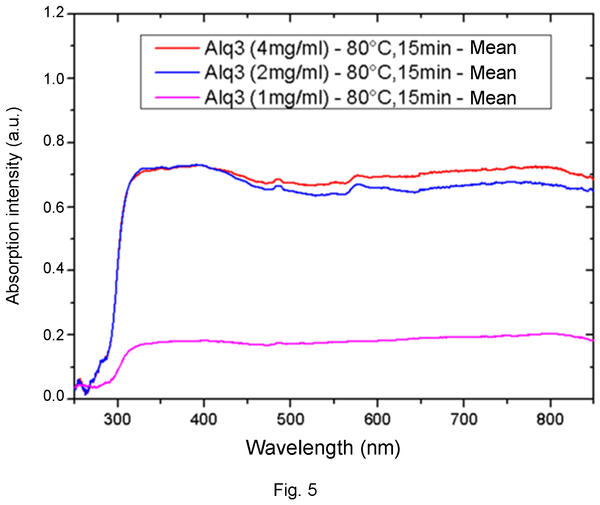

Fig. 5 shows the UV-visible absorption profile of Alq3 solutions at concentrations of 4 mg/mL, 2 mg/mL, and 1 mg/mL heated at 80°C for 15 min.

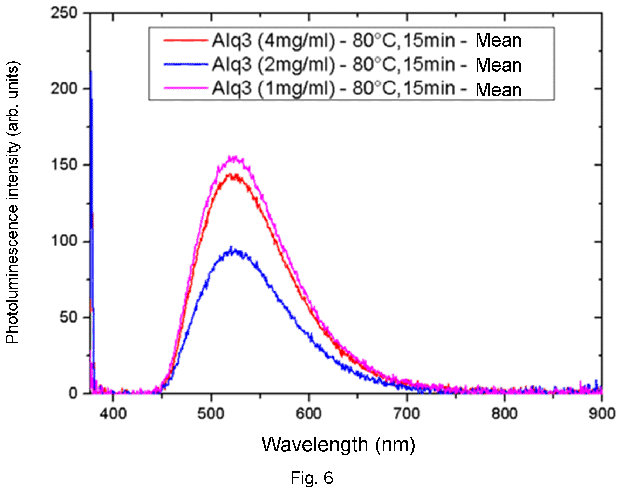

Fig. 6 shows an emission spectrum (PL - photoluminescence ) of Alq3 solutions at concentrations of 4 mg/mL, 2 mg/mL, and 1 mg/mL heated at 80°C for 15 min.

The PLQY (Photoluminescence Quantum Yield) results for the samples in Figure 6 are in Table 1 below.

**Table 1 - PLQY of the samples in Figure 6**

| **Sample** | **PLQY (%)** |
|---|---|
| Alq3 (4 mg/mL) - 80°C, 15 min | 24.8 ± 0.5 |
| Alq3 (2 mg/mL) - 80°C, 15 min | 24.8 ± 1.5 |
| Alq3 (1 mg/mL) - 80°C, 15 min | 26.1 ± 0.1 |

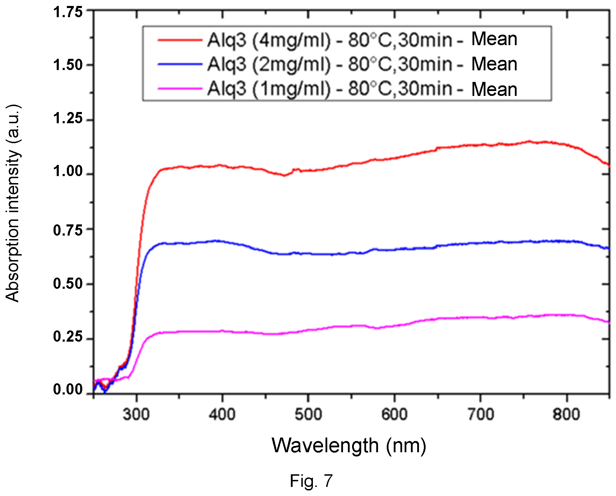

Fig. 7 shows the UV-visible absorption profile of Alq3 solutions at concentrations of 4 mg/mL, 2 mg/mL, and 1 mg/mL heated at 80°C for 30 min.

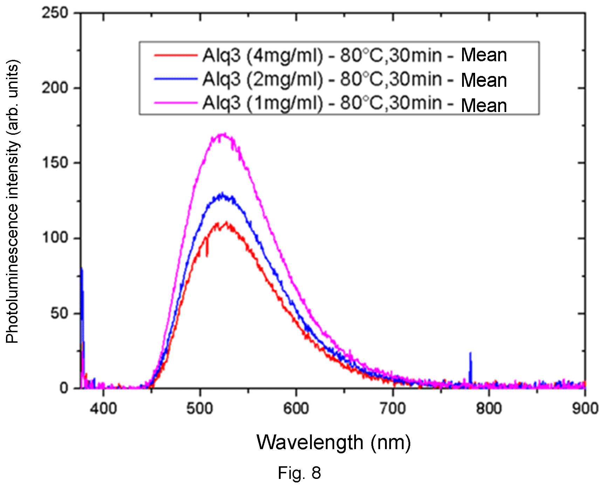

Fig. 8 shows an emission spectrum (PL - photoluminescence ) of Alq3 solutions at concentrations of 4 mg/mL, 2 mg/mL, and 1 mg/mL heated at 80°C for 30 min.

The PLQY (Photoluminescence Quantum Yield) results for the samples in Figure 8 are in Table 2 below.

**Table 2 - PLQY of the samples in Figure 6**

| **Sample** | **PLQY (%)** |
|---|---|
| Alq3 (4 mg/mL) - 80°C, 30 min | 25.2 ± 0.1 |
| Alq3 (2 mg/mL) - 80°C, 30 min | 23.1 ± 0.1 |
| Alq3 (1 mg/mL) - 80°C, 30 min | 25.8 ± 0.1 |

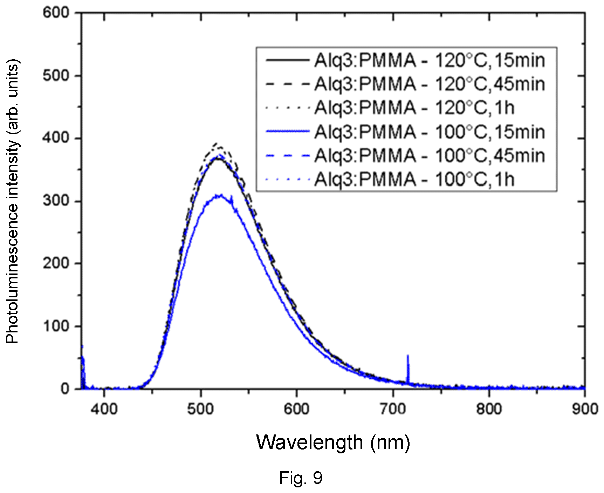

Fig. 9 shows an emission spectrum (PL - photoluminescence) of polymer solutions prepared as described in Example 1 for Alq3:PMMA composites heated at 120°C for 15 min, 120°C for 45 min, 120°C for 1 h, 100°C for 15 min, 100°C for 45 min, 100°C for 1 h.

The PLQY (Photoluminescence Quantum Yield) results for the samples in Figure 9 are in Table 3 below.

**Table 3 - PLQY of the samples in Figure 9**

| **Sample** | **PLQY (%)** |
|---|---|
| Alq3:PMMA - 120°C, 15 min | 31.2 ± 0.1 |
| Alq3:PMMA - 120°C, 45 min | 32.8 ± 0.5 |
| Alq3:PMMA - 120°C, 1 h | 32.6 ± 0.1 |
| Alq3:PMMA - 100°C, 15 min | 27.5 ± 0.5 |
| Alq3:PMMA - 100°C, 45 min | 32.1 ± 0.5 |
| Alq3:PMMA - 100°C, 1 h | 28.2 ± 0.1 |

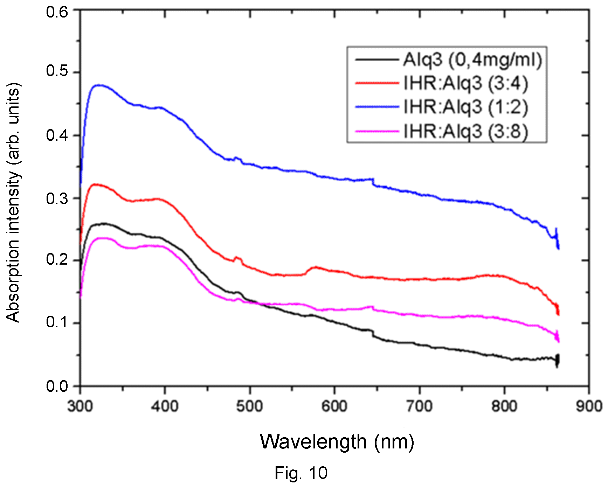

Fig. 10 shows the UV-visible absorption profile of Alq3 solutions at a concentration of 0.4 mg/mL compared with mixtures of Nb and Alq3 nanoparticles at different ratios (3:4; 1:2, and 3:8).

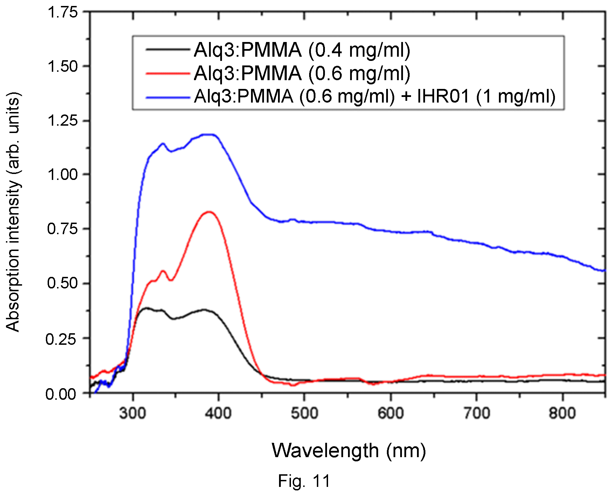

Fig. 11 shows the UV-visible absorption profile of Alq3:PMMA polymer solutions at concentrations of 0.4 mg/mL and 0.6 mg/mL compared to an Alq3:PMMA polymer solution at a concentration of 0.6 mg/mL containing Nb nanoparticles (1 mg/mL).

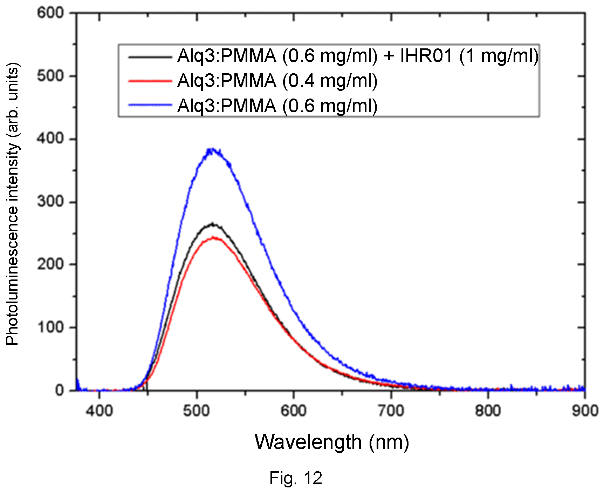

Fig. 12 shows an emission spectrum (PL - photoluminescence) of the polymer solutions shown in Fig. 11.

The PLQY (Photoluminescence Quantum Yield) results for the samples in Figure 12 are in Table 4 below.

**Table 4 - PLQY of the samples in Figure 12**

| **Sample** | **PLQY (%)** |
|---|---|
| Alq3:PMMA (0.4 mg/mL) | 19.75 ± 4.50 |
| Alq3:PMMA (0.6 mg/mL) | 29.86 ± 1.15 |
| Alq3:PMMA (0.6 mg/mL) + IHR01 (1 mg/mL) | 40.93 ± 0.73 |

The results in Table 4 clearly show a significant increase in PLQY of the Alq3:PMMA protective layer containing niobium nanoparticles.

Without wishing to be bound by theory, it is understood that the samples subjected to 12 hours of milling, which exhibit a higher degree of amorphization (74%), contribute to the surprising effects observed.

### Example 4 - Photoluminescence spectra

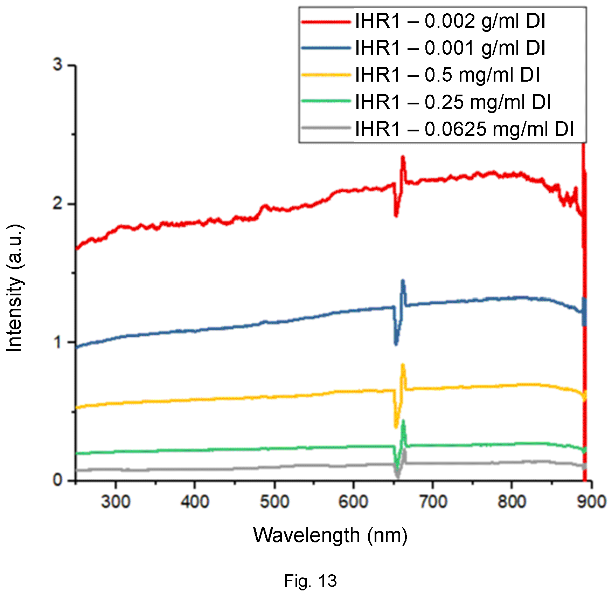

Fig. 13 shows an emission spectrum (PL - photoluminescence) of niobium nanoparticle solutions at different concentrations in deionized water.

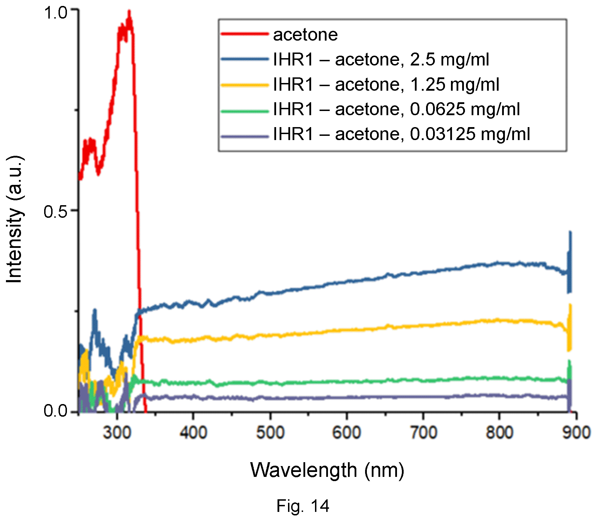

Fig. 14 shows an emission spectrum (PL - photoluminescence) of niobium nanoparticle solutions at different concentrations in acetone.

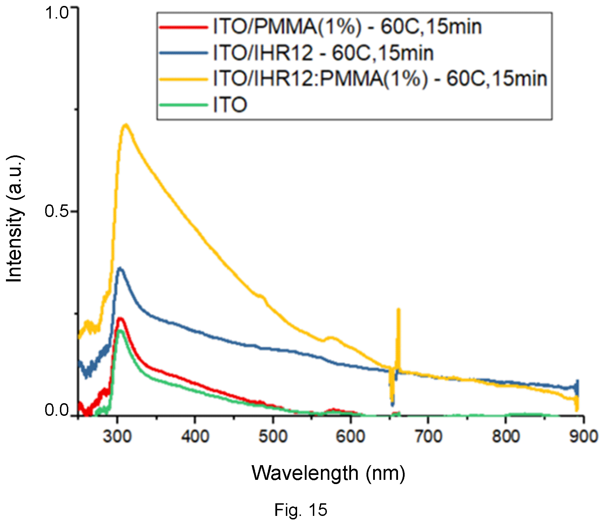

Fig. 15 shows an emission spectrum (PL - photoluminescence) of ITO (tin-doped indium oxide) polymer solutions, ITO with niobium nanoparticles, ITO with PMMA (1%), and ITO with niobium nanoparticles in PMMA (1%) heated to 60°C for 15 min, except for the ITO sample.

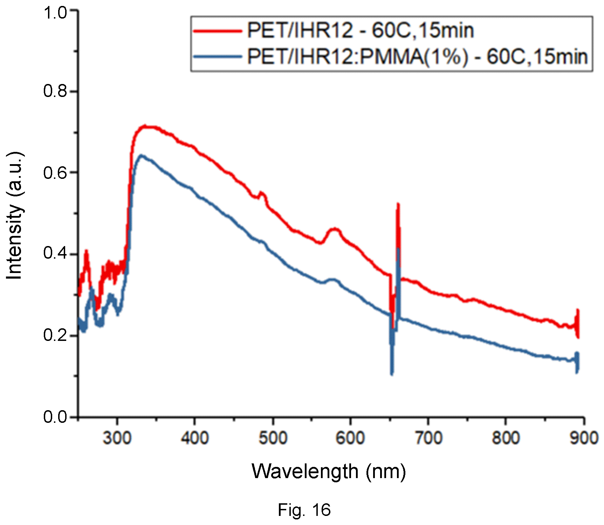

Fig. 16 shows an emission spectrum (PL - photoluminescence) of PET (polyethylene terephthalate) polymeric solutions with niobium nanoparticles, PET (polyethylene terephthalate) with niobium nanoparticles in PMMA (1%) heated to 60°C for 15 min.

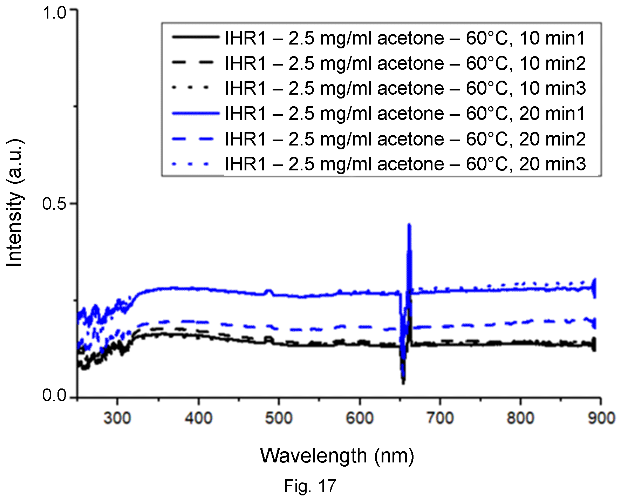

Fig. 17 shows an emission spectrum (PL - photoluminescence) of niobium nanoparticle solutions at a concentration of 2.5 mg/mL in acetone, heated to 60°C for 10 min or 20 min (in triplicate).

### Example 5 - Resistance measurements (Ω)

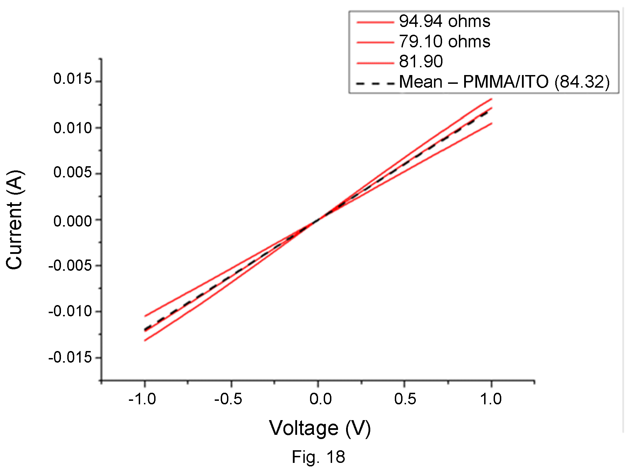

Fig. 18 shows a graph of current (A) versus voltage (V) for measuring the resistance (Ω) of a PMMA/ITO sample.

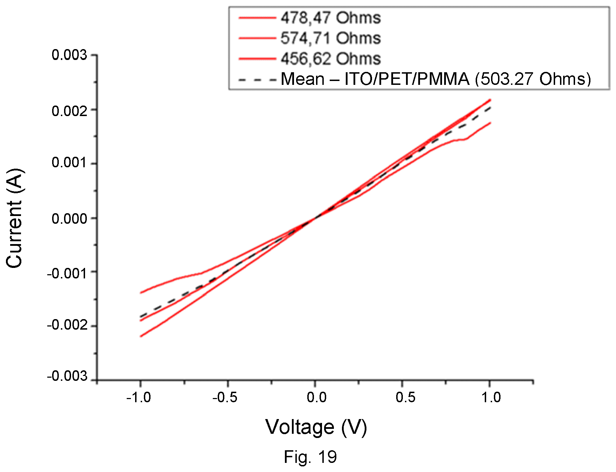

Fig. 19 shows a graph of current (A) versus voltage (V) for measuring the resistance (Ω) of an ITO/PET/PMMA sample.

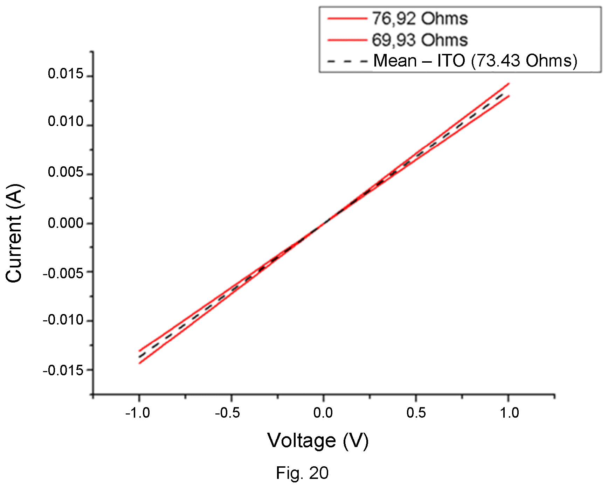

Fig. 20 shows a graph of current (A) versus voltage (V) for measuring the resistance (Ω) of an ITO sample.

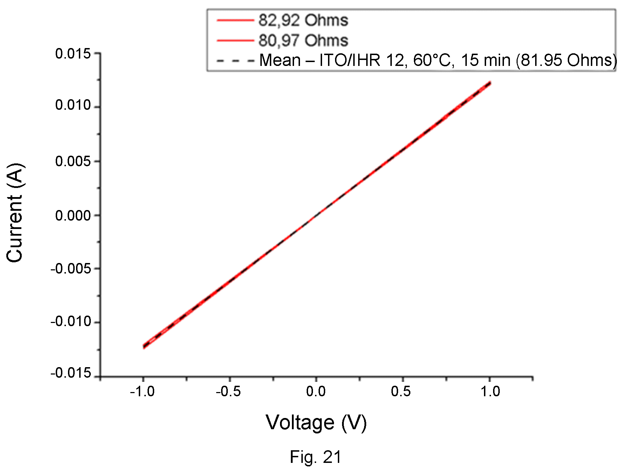

Fig. 21 shows a graph of current (A) versus voltage (V) for measuring the resistance (Ω) of an ITO sample with niobium nanoparticles treated at 60°C for 15 min.

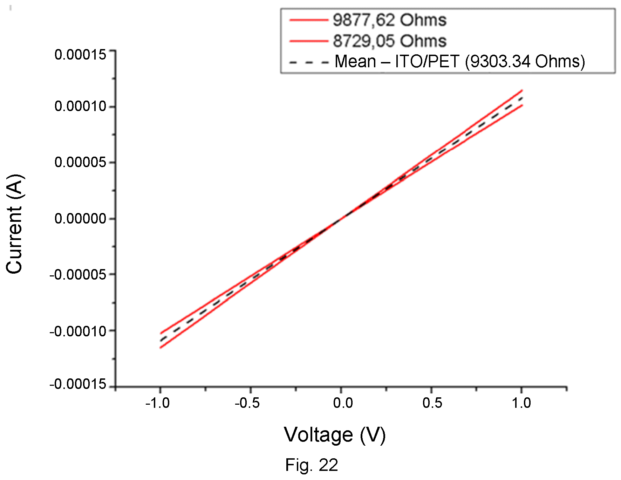

Fig. 22 shows a graph of current (A) versus voltage (V) for measuring the resistance (Ω) of an ITO/PET sample.

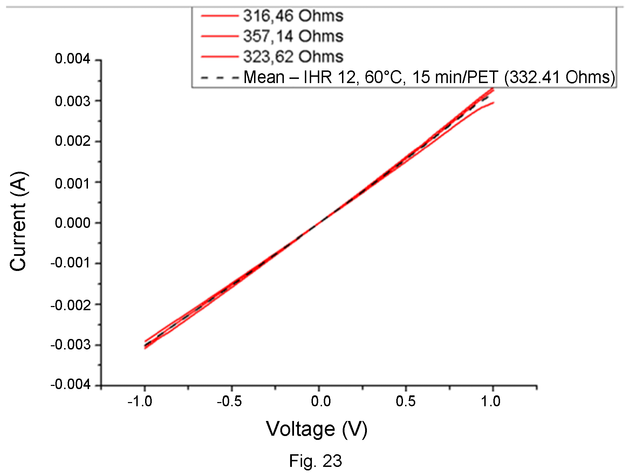

Fig. 23 shows a graph of current (A) versus voltage (V) for measuring the resistance (Ω) of a PET sample with niobium nanoparticles treated at 60°C for 15 min.

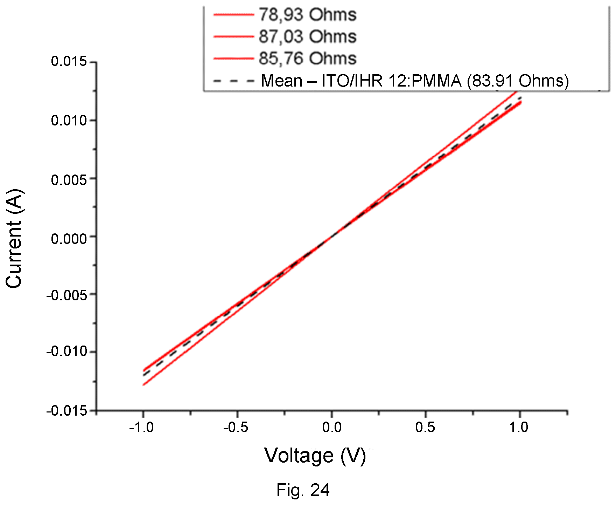

Fig. 24 shows a graph of current (A) versus voltage (V) for measuring the resistance (Ω) of an ITO sample with niobium nanoparticles in PMMA.

Those skilled in the art will appreciate the knowledge disclosed herein and will be able to reproduce the invention in the disclosed embodiments and in other variants and alternatives thereof. encompassed by the scope of the following claims.

## Claims

1. A photovoltaic cell comprising:
- an active layer;
- an electron transport layer in contact with one face of the active layer;
- a hole transport layer in contact with one face of the active layer;
- a transparent conductive substrate in contact with the electron transport layer or the hole transport layer;
- a counter electrode in contact with the electron transport layer or the hole transport layer;
**characterized in that** it additionally comprises:
- a protective layer in contact with the transparent conductive substrate;
wherein at least one of said layers comprises a mass quantity of niobium nanoparticles, wherein said mass quantity of nanoparticles comprises a degree of amorphization of at least 19%.

2. The photovoltaic cell of claim 1, **characterized in that** the mass quantity of niobium nanoparticles is comprised within said protective layer.

3. The photovoltaic cell of claim 1, **characterized in that** the mass quantity of nanoparticles preferably comprises a degree of amorphization of at least 39%, preferably a degree of amorphization of at least 55% and even more preferably a degree of amorphization of at least 70%.

4. The photovoltaic cell of claim 1, **characterized in that** active layer is comprised of perovskite.

5. The photovoltaic cell of claim 1, **characterized in that** the protective layer is comprised of PMMA and Alq3 dye.

6. The photovoltaic cell of claim 1, **characterized in that** the niobium nanoparticle is a niobium pentoxide nanoparticle.

7. Use of niobium nanoparticles, **characterized in that** it is as a dopant in at least one layer of a photovoltaic cell, wherein said nanoparticles comprise a degree of amorphization of at least 19%.

8. The use of claim 7, **characterized in that** the niobium nanoparticle is niobium pentoxide nanoparticle.

9. A method of producing energy, **characterized in that** it comprises a step of incidence of electromagnetic radiation over a photovoltaic cell as defined in claim 1.

10. The method of claim 9, **characterized in that** the energy is solar energy and said electromagnetic radiation originates from the sun.

11. A method for increasing the photoluminescence quantum yield in a solar cell, **characterized in that** it comprises at least one step of incorporating niobium nanoparticles into at least one protective layer of said solar cell, wherein said protective layer is in contact with the transparent conductive substrate of said solar cell.

12. The method of claim 11, **characterized in that** said protective layer is comprised of PMMA and Alq3 dye.
